# EUROPÄISCHE PATENTSCHRIFT

(11) **EP 1 008 193 B1**
(45) Veröffentlichungstag und Bekanntmachung des Hinweises auf die Patenterteilung: **06.10.2004**
(21) Anmeldenummer: 98959777.8
(22) Anmeldetag: 30.10.1998
(51) Int. Cl.: H01L 41/24

(54) **VERFAHREN ZUR HERSTELLUNG PIEZOELEKTRISCHER AKTOREN UND PIEZOELEKTRISCHER AKTOR**
METHOD FOR THE PRODUCTION OF PIEZOELECTRIC ACTUATORS AND A PIEZOELECTRIC ACTUATOR
PROCEDE DE PRODUCTION D'ACTIONNEURS PIEZO-ELECTRIQUES, ET ACTIONNEUR PIEZO-ELECTRIQUE

(30) Priorität: 24.12.1997 DE 19757877
(43) Veröffentlichungstag der Anmeldung: 14.06.2000
(73) Patentinhaber: ROBERT BOSCH GMBH, 70442 Stuttgart (DE)
(72) Erfinder: SEIPLER, Dieter, D-72766 Reutlingen (DE); RÖTHLINGSHÖFER, Walter, D-72766 Reutlingen (DE); NISHIGAKI, Susumu, Nagoya (JP)
(86) Internationale Anmeldenummer: PCT/DE1998/003174
(87) Internationale Veröffentlichungsnummer: WO 1999/034455

(56) Entgegenhaltungen:
- WO-A-97/01868
- US-A- 4 523 121
- PATENT ABSTRACTS OF JAPAN vol. 012, no. 054 (E-583), 18. Februar 1988 -& JP 62 199075 A (FUJI ELELCTROCHEM CO LTD), 2. September 1987

## Beschreibung

### Stand der Technik

Die Erfindung betrifft einen piezoelektrischen Aktor, der insbesondere zur Betätigung eines Brennstoffeinspritzventils verwendbar ist, sowie ein Verfahren zu dessen Herstellung.

Piezoelektrische Aktoren, insbesondere zur Betätigung von Brennnstoffeinspritzventilen, sind in vielfältigen Bauformen beispielsweise aus der DE 195 00 706 A1 oder der DE 43 06 073 C1 bekannt. Die piezoelektrischen Aktoren bestehen aus mehreren übereinander gestapelten piezoelektrischen Schichten, die jeweils an einer Oberfläche mit einer Elektrode beschichtet sind. Übliche Piezoaktoren bestehen aus mehreren hundert derart übereinander geschichteten piezoelektrischen Schichten. Auf diese Weise wird ein relativ großer Betätigungshub erreicht. Wie z. B. in der DE 37 13 697 A1 näher dargestellt, müssen die Elektroden der einzelnen piezoelektrischen Schichten alternierend mit einer Spannungsquelle verbunden werden, um in den einzelnen Schichten ein in gleicher Richtung ausgerichtetes elektrisches Feld zu erzeugen. Dabei ist jede zweite Elektrode mit einem ersten Pol einer Spannungsquelle verbunden, während die dazwischenliegenden Elektroden mit einem zweiten Pol einer Spannungsquelle verbunden sind. Wie z. B. in der GB 2 193 386 A näher dargestellt, ist es bislang üblich, die sich bis an den Rand der gestapelten piezoelektrischen Schichten erstreckenden Elektroden im Randbereich außenseitig miteinander zu verbinden. Diese Kontaktierungsart ist jedoch bei einer vollautomatischen Fertigung mit großen Stückzahlen aufwendig und störungsanfällig und hat zudem den Nachteil, daß die. Elektroden aufgrund ihrer Erstreckung bis in den Randbereich gegenüber der Umgebung nicht isoliert sind, so daß der Mantelbereich der piezoelektrischen Aktoren mit einer zusätzlichen Isolierung versehen werden muß.

Aus der US 4,523,121 A ist bereits ein piezoelektrischer Aktor, der eine Vielzahl von übereinander angeordneten Schichten aus einem piezoelektrischen Keramikwerkstoff aufweist, wobei jeweils eine Oberfläche der Schichten mit einer Elektrode beschichtet ist. In jeder Schicht ist eine erste und zweite die Schicht im Bereich der Elektrode durchdringende Verbindungsöffnung vorgesehen, wobei jede Elektrode eine größere Aussparung aufweist, die entweder die erste oder zweite Verbindungsöffnung umgibt. Die Schichten sind so gestapelt, dass die ersten und zweiten Verbindungsöffnungen sämtlicher Schichten übereinander angeordnet sind und die übereinander angeordneten Verbindungsöffnungen alternierend nur in jeder zweiten Schicht von der jeweiligen Aussparung der Elektroden umgeben sind, so dass die Elektroden abwechselnd mit den ersten Verbindungsöffnungen und den zweiten Verbindungsöffnungen in Verbindung stehen. Die Verbindungsöffnungen werden von Kontaktsäulen über die Gesamtlänge des Piezoaktors durchgriffen, die mit einer Platinpaste erzeugt werden.

### Vorteile der Erfindung

Das erfindungsgemäße Verfahren mit den Merkmalen des Anspruchs 1 hat den Vorteil, daß es in einer vollautomatischen Fertigung einsetzbar ist und zu sehr geringen Fertigungskosten führt. Die Elektroden des Aktors werden nicht an der Außenseite sondern dem Inneren durch eine in Verbindungsöffnungen eingebrachte elektrisch leitende Paste kontaktiert. Die Kontaktierung ist daher wenig störanfällig und unanfällig gegen äußere mechanische Beschädigungen. Die piezoelektrischen Aktoren werden in einem hochintegrierten Fertigungsprozeß parallel zueinander hergestellt. Ein mehrere piezoelektrische Aktoren beinhaltender Block wird erst am Ende der Fertigung in die einzelnen Aktoren zerlegt. Die Fertigungsausbeute läßt sich dadurch erheblich erhöhen. Dass ein Randbereich der Aktoren von den Elektroden erfindungsgemäß ausgespart ist, hat den Vorteil, daß die Elektroden von der Umgebung des Aktors zuverlässig isoliert sind. Es sind daher keine weiteren Maßnahmen zur Isolierung der Elektroden erforderlich. Da zudem die Kontaktierung der Elektroden über Verbindungsöffnungen im Inneren des Aktors erfolgt, ergibt sich eine vollständige Isolierung aller spannung führenden Bauteile nach außen. Die Störanfälligkeit des Aktors wird deutlich vermindert. Die gleichen Vorteile ergeben sich auch für den erfindungsgemäßen Aktor mit den Merkmalen des Anspruchs 9.

Durch die in den Unteransprüchen aufgeführten Maßnahmen sind vorteilhafte Weiterbildungen und Verbesserungen des im Anspruch 1 angegebenen Herstellungsverfahrens bzw. des im Anspruch 9 angegebenen piezoelektrischen Aktors möglich.

In den Zwischenbereichen zwischen den einzelnen Aktoren können in den die piezoelektrischen Schichten bildenden Folien Perforationslöcher ausgebildet werden. Diese Perforationslöcher dienen einerseits als Entgasungskanäle beim anschließenden Brennen der gestapelten Folien. Andererseits erleichtern die Perforationslöcher das Zertrennen der gestapelten Anordnung in die einzelnen Aktoren. Das Zertrennen kann dabei z. B. dadurch erfolgen, daß die Elektroden benachbarter Aktoren mit einem elektrischen Feld entgegengesetzt der Polarität beaufschlagt werden. Während der eine benachbarte Aktor kontrahiert, expandiert der andere benachbarte Aktor. Die sich dadurch ergebende mechanische Spannung führt zu einem Auseinanderbrechen der Aktoren entlang der durch die Perforationslöcher vorgegebenen Trennlinie. Die Perforationslöcher erleichtern jedoch auch ein Zertrennen der Aktoren durch Sägen entlang der durch die Perforationslöcher vorgegebenen Perforationslinie. Ein anderes geeignetes Zertrennungsverfahren ist das Wasserstrahlschneiden.

Die metallischen Elektroden können vorteilhaft durch ein Siebdruckverfahren, Aufdampfen oder Sputtern aufgebracht werden, wobei es aus Gründen der Materialeinsparung und besseren Haftvermittlung mit der darüber liegenden piezoelektrischen Keramikschicht vorteilhaft ist, die Elektroden nicht vollflächig sondern mit einer z. B. netzartigen Struktur aufzubringen.

### Zeichnung

Ein Ausführungsbeispiel der Erfindung ist in der Zeichnung vereinfacht dargestellt und in der nachfolgenden Beschreibung näher erläutert.

Es zeigen:
- Fig. 1: eine schematische Darstellung von drei aufeinander zu stapelnden Folien aus einem piezoelektrischen Keramikmaterial, die mit Elektroden beschichtet sind und mit Verbindungsöffnungen und Perforationslöchern versehen sind; und
- Fig. 2: einen fertigen Aktor in einer geschnittenen, perspektivischen Darstellung.

### Beschreibung des Ausführungsbeispiels

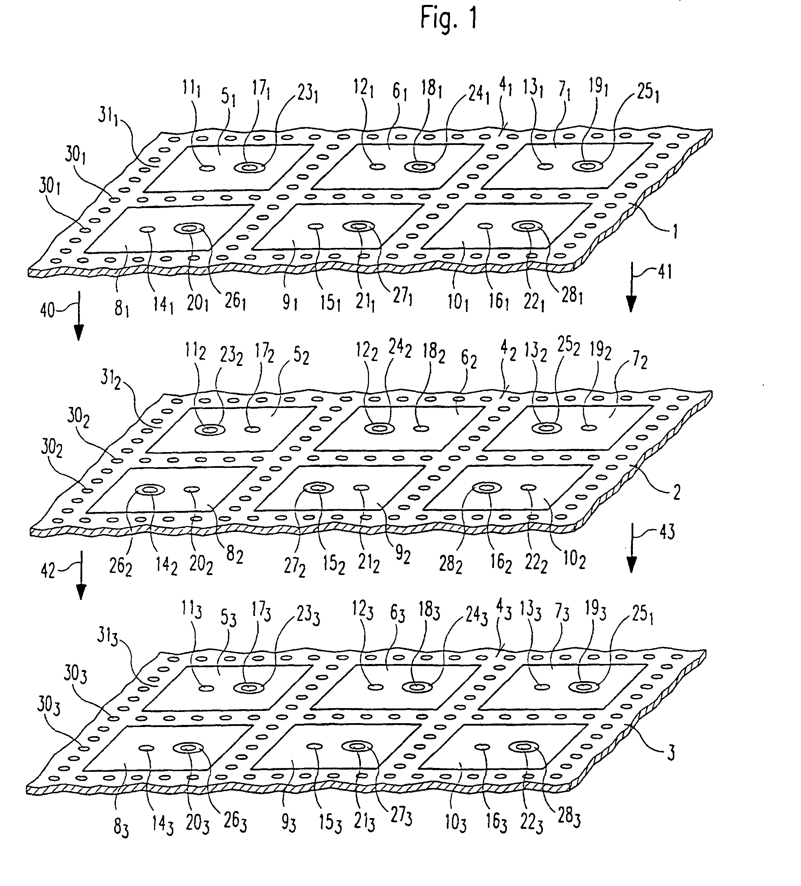

Fig. 1 zeigt eine perspektivische, schematische Darstellung zur Veranschaulichung des erfindungsgemäßen Herstellungsverfahrens. Dargestellt sind drei Folien 1, 2 und 3 aus einem noch ungebrannten, piezoelektrischen Keramikwerkstoff, d. h. aus sogenannter grüner Keramik. Ein geeigneter Werkstoff ist z. B. Blei-Barium-Titanat (PbBaTiO₂). Der keramische Werkstoff läßt sich vor dem Brennen z. B. durch Walzen, Gießen oder Schneiden zu dünnen Folien verarbeiten. Die Größenordnung der Foliendicke liegt bei beispielsweise 0,1 mm, ohne daß die Ausführbarkeit der Erfindung auf diese Foliendicke beschränkt wäre. In einem nächsten Verarbeitungsschritt werden die Folien an ihrer Oberseite 4₁, 4₂, 4₃ mit einem elektrisch leitfähigen Material, vorzugsweise mit einer dünnen Metallschicht, beschichtet. Dazu sind alle bekannten chemischen und physikalischen Oberflächenbeschichtungsverfahren, z. B. Aufdampfen, Sputtern oder ein Siebdruckverfahren geeignet. Die Elektroden 5₁ bis 10₁, 5₂ bis 10₂ und 5₃ bis 10₃ können ganzflächig aufgebracht werden. Bei einem Siebdruckverfahren ist jedoch eine netzartige Struktur der Elektroden zweckmäßig. Im dargestellten Ausführungsbeispiel ist jeweils eine Elektrode 5₁ bis 10₁, 5₂ bis 10₂ bzw. 5₃ bis 10₃ einer jeden Folie 1, 2 bzw. 3 einem Aktor zugeordnet. Es werden daher mehrere seitlich versetzt zueinander angeordnete Aktoren durch das erfindungsgemäße Verfahren gleichzeitig prozessiert, wodurch die Herstellungskosten deutlich reduziert werden können. Grundsätzlich ist es auch möglich, jedem Aktor nicht nur eine, sondern mehrere Elektroden zuzuordnen, wenn dies für einzelne Anwendungsfälle wünschenswert ist.

In jeder Folien-Schicht 1, 2 bzw. 3 werden in einem der Beschichtung nachfolgenden oder vorhergehenden Arbeitsschritt erste Verbindungsöffnungen 11₁ bis 16₁ in der ersten Folie 1, 11₂ bis 16₂ in der zweiten Folie 2 und 11₃ bis 16₃ in der dritten Folie 3 sowie zweite Verbindungsöffnungen 17₁ bis 22₁ in der ersten Folie 1, 17₂ bis 22₂ in der zweiten Folie 2 und 17₃ bis 23₃ in der dritten Folie 3 z. B. durch Stanzen oder Bohren ausgebildet. Die Verbindungsöffnungen 11 bis 22 dienen der Kontaktierung der einzelnen Elektroden 5 bis 10, worauf noch näher eingegangen wird. Um eine alternierende Verbindung zwischen den Elektroden zu erzielen, sind bei der ersten Folie 1 die zweiten Verbindungsöffnungen 17₁ bis 22₁ jeweils von einer Aussparung 23₁ bis 28₁ umgeben, d. h. die Elektroden-Beschichtung reicht nicht bis zum Rand der zweiten Verbindungsöffnungen 17₁ bis 22₁, sondern der Rand der Elektroden 5₁ bis 10₁ ist von dem Rand der zweiten Verbindungsöffnungen 17₁ bis 22₁ beabstandet. In ähnlicher Weise sind auch bei den Elektroden 5₃ bis 10₃ der dritten Folie 3 Aussparungen 23₃ bis 28₃ vorgesehen, die die zweiten Verbindungsöffnungen 17₃ bis 22₃ umgeben. In der dazwischen liegenden, zweiten Folienschicht hingegen umgeben die Aussparungen 23₂ bis 28₂ der Elektroden 5₂ bis 10₂ die ersten Verbindungsöffnungen 11₂ bis 16₂. Gleiches gilt auch für eine nicht mehr dargestellte oberhalb der ersten Folie 1 angeordnete an diese angrenzende, weitere Folie und eine ebenfalls nicht mehr dargestellte unterhalb der dritten Folie 3 angeordnete und an diese angrenzende weitere Folie. Die Aussparungen 23 bis 28 sind daher alternierend von Folien-Schicht zu Folien-Schicht jeweils den ersten Verbindungsöffnungen 11 bis 16 oder den zweiten Verbindungsöffnungen 17 bis 22 zugeordnet.

Ferner sind im dargestellten Ausführungsbeispiel Perforationslöcher 30₁, 30₂ und 30₃ in jeder Folienschicht 1, 2 bzw. 3 vorgesehen, die z. B. durch Stanzen oder Bohren gleichzeitig mit den ersten Verbindungsöffnungen 11 bis 16 und den zweiten Verbindungsöffnungen 17 bis 22 ausgebildet werden können. Die Perforationslöcher 30 sind im dargestellten Ausführungsbeispiel netzartig ausgebildet und markieren jeweils die Grenzlinie zwischen den einzelnen mit dem erfindungsgemäßen Verfahren gleichzeitig hergestellten Aktoren. Zwischen den Elektroden 5₁ bis 10₁ bzw. 5₂ bis 10₂ bzw. 5₃ bis 10₃ sind in jeder Folie netzartige Zwischenbereiche 31₁ bzw. 31₂ bzw. 31₃ vorgesehen, so daß die Elektroden 5 bis 10 nicht bis zum äußeren Rand der Aktoren reichen, sondern von dem durch die Perforationslöcher 30 markierten Rand beabstandet sind. Die Perforationslöcher 30 sind vorzugsweise in den Zwischenbereichen 31 in Reihen angeordnet, die sich entlang der Ränder der einzelnen Aktoren erstrecken. Im dargestellten Ausführungsbeispiel werden Aktoren mit rechteckigen Querschnitt hergestellt. Zur Herstellung von Aktoren mit anderen Querschnittsflächen sind die Perforationslöcher entsprechend variiert anzuordnen.

In einem nachfolgenden Bearbeitungsschritt werden eine Vielzahl von Folien, von welchen in Fig. 1 nur ausschnittsweise die Folien 1 bis 3 dargestellt sind, übereinander gestapelt. Zur Erzielung eines ausreichenden Aktorhubs werden vorzugsweise mehrere hundert der in Fig. 1 dargestellten, wie vorgeschrieben behandelten Folien aufeinander geschichtet. Die einzelnen Folien-Schichten werden dabei so zueinander ausgerichtet, daß sowohl die Perforationslöcher 30 als auch die ersten Verbindungsöffnungen 11 bis 16 und die zweiten Verbindungsöffnungen 17 bis 22 exakt übereinander positioniert sind. Dies kann z. B. vollautomatisch mit einem mechanisch oder optisch abtastbaren Referenz-Markierungs-System erfolgen. Das Stapeln bzw. Schichten der einzelnen Folien 1 bis 3 ist in Fig. 1 durch die Pfeile 40 bis 43 veranschaulicht. Wie bereits erläutert, wird die Schichtenfolge der Folien 1 bis 3 so gewählt, daß die übereinander angeordneten Verbindungsöffnungen 11 bis 16 bzw. 17 bis 22 alternierend nur in jeder zweiten Folien-Schicht 1 bis 3 von einer Aussparung 23 bis 28 der Elektroden 5 bis 10 umgeben sind, so daß die Elektroden 5 bis 10 abwechselnd mit den ersten Verbindungsöffnungen 11 bis 16 oder den zweiten Verbindungsöffnungen 17 bis 22 in Verbindung stehen.

In einem weiteren Bearbeitungsschritt werden die ersten Verbindungsöffnungen 11 bis 16 und die zweiten Verbindungsöffnungen 17 bis 22 mit einer geeigneten, elektrisch leitenden Paste, z. B. einer Metallisierungspaste, gefüllt. Das Füllen der Verbindungsöffnungen 11 bis 16 bzw. 17 bis 22 kann z. B. durch Einsaugen mittels Unterdruck oder durch Einpressen erfolgen. Bevorzugt erfolgt das Einbringen der elektrisch leitenden Paste in dem bereits gestapelten Zustand der Folien. Denkbar ist es jedoch auch, daß jede einzelne Folie vor dem Stapeln mit der elektrisch leitenden Paste gefüllt wird. Die Verbindungsöffnungen 11 bis 16 bzw. 17 bis 22 können auch als sogenannte Via-Löcher bezeichnet werden, so daß dem Kontaktierungsverfahren die Bezeichnung Via-Fill-Prozeß zukommt.

In einem nachfolgenden Bearbeitungsschritt wird die durch das Stapeln der Folien 1 bis 3 entstehende gestapelte Anordnung unter einem geeigneten Druck bei erhöhter Temperatur getrocknet und anschließend bei einer geeigneten Temperatur gebrannt. Die BrennTemperatur ist vorzugsweise größer als 1000° C und liegt bevorzugt im Bereich zwischen 1000° C und 1500° C.

Anschließend wird die gebrannte, gestapelte Anordnung in die Einzelaktoren zerlegt. Bei einer Foliengröße von beispielsweise 15 x 20 cm lassen sich bis zu 200 Einzel-Aktoren aus der gestapelten Anordnung gewinnen. Das Zertrennen in die Einzel-Aktoren erfolgt z. B. durch Sägen oder durch Wasserstrahlschneiden. Die Perforationslöcher 30 erleichtern dabei den Trennvorgang und markieren die Trennstelle.

Entsprechend einer bevorzugten Vorgehensweise erfolgt das Trennen der gestapelten Anordnung in die Einzel-Aktoren dadurch, daß benachbarte Aktoren mit einer elektrischen Spannung unterschiedlicher Polarität beaufschlagt werden. Durch das sich in den einzelnen Schichten des Aktors ausbildende elektrische Feld, welches zwischen benachbarten Aktoren in unterschiedlicher Richtung ausgerichtet ist, ergibt sich je nach Feldrichtung entweder eine Kontraktion oder Expansion der benachbarten Aktoren. Zwischen den benachbarten Aktoren tritt deshalb eine mechanische Verspannung auf, die bei geeigneter Dimensionierung der elektrischen Feldstärke und des Abstands zwischen den einzelnen Perforationslöchern 30 zu einem Zertrennen der Aktoren entlang der durch die Perforationslöcher 30 vorgegebenen Trennlinie führt. Diese Vorgehensweise ist besonders kostensparend, da es keiner besonderen Trennvorrichtung bedarf.

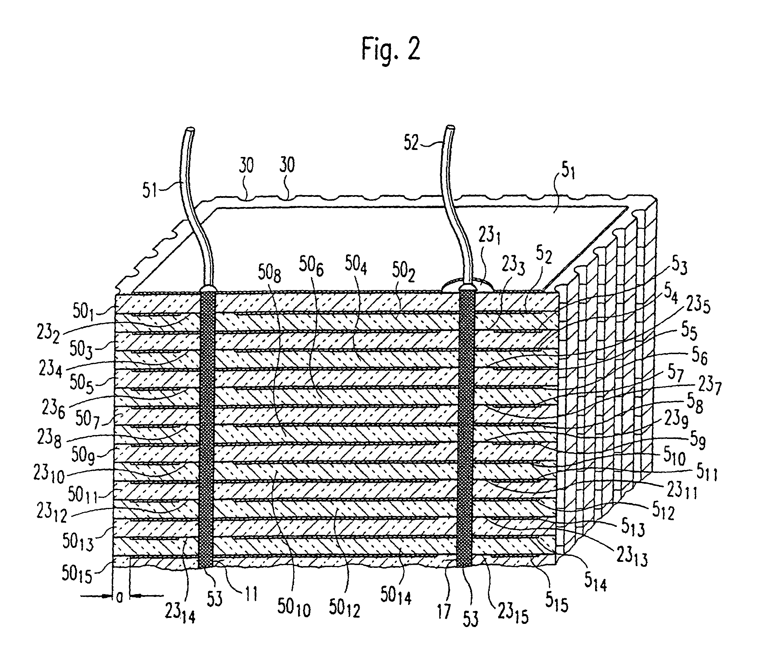

Zur besseren Veranschaulichung der Erfindung ist in Fig. 2 ein Einzel-Aktor geschnitten dargestellt. Erkennbar sind die gestapelt übereinander angeordneten Schichten 50₁ bis 50₁₅ aus piezoelektrischem Keramikwerkstoff. Erkennbar sind ferner die Elektroden 5₁ bis 5₁₅ der einzelnen Schichten 50₁ bis 50₁₅. Wie in Fig. 2 nochmals verdeutlicht, sind die Aussparungen 23₁ bis 23₁₅ der Elektroden 5₁ bis 5₁₅ alternierend so angeordnet, daß sie abwechselnd die erste Verbindungsöffnung 11 und die zweite Verbindungsöffnung 17 umgeben. Durch die in die Verbindungsöffnungen 11 und 17 eingefüllte, elektrisch leitfähige Paste 53 werden die Elektroden 5₁, 5₃, ... 5₁₅ jeweils jeder zweiten Schicht mit einem z. B. durch Löten, Bonden, Schweißen oder dergleichen mit dem Aktor verbundenen, ersten Anschlußdraht 51 verbunden. Die dazwischenliegenden Elektroden 5₂, 5₄, ...5₁₄ werden über die in die zweiten Verbindungsöffnungen 17 eingeführte elektrisch leitfähige Paste 53 mit einem zweiten Anschlußdraht 52 verbunden. Das sich in dem Aktor bei Anlegen einer elektrischen Spannung zwischen den Anschlußdrähten 51 und 52 ausbildende elektrische Feld ist daher in sämtlichen piezoelektrischen Schichten 50₁ bis 50₁₅ in gleicher Richtung ausgerichtet, so daß sich die Kontraktion bzw. Expansion jeder einzelnen piezoelektrischen Schicht 15₁ bis 15₁₅ konstruktiv zu einem Gesamthub des piezoelektrischen Aktors addiert.

Aus Fig. 2 sind ferner die ausgebrochenen Perforationslöcher 30 im Randbereich des Aktors zu erkennen. Dadurch, daß die Elektroden 5₁ bis 5₁₅ sich nicht bis zum Randbereich des Aktors erstrecken, sondern durch einen Abstand a von dem Rand beabstandet sind, ergibt sich eine hermetische Isolation der Elektroden 5₂ bis 5₁₅. Lediglich für die oberste Elektrode 5₁ ist eine zusätzliche Isolationsmaßnahme vorzusehen. Vorzugsweise wird der Aktor an seiner Oberseite durch eine geeignete elektrisch isolierende Vergußmasse abgedeckt. Diese Vergußmasse kann bereits vor dem Zertrennen der gestapelten Anordnung in die Einzel-Aktoren flächig aufgebracht werden. Ferner ist es denkbar, an der Oberseite als abschließende Schicht eine elektrisch isolierende AbdeckFolie aufzubringen.

Die Perforationslöcher 30 erleichtern nicht nur das Zertrennen der gestapelten Anordnung in Einzel-Aktoren, sondern unterstützen insbesondere auch als Entgasungskanäle die Gasentweichung beim Trocknen und Brennen der gestapelten Anordnung. Durch das erfindungsgemäße Verfahren lassen sich piezoelektrische Aktoren herstellen, die mit einer Arbeitsspannung von weniger als 150 V auskommen und eine Kraft von mehr als 1000 N bei einem Betätigungshub von 50 *µ*m erzeugen. Durch Wasserschneiden läßt sich die gestapelte Anordnung in Einzelaktoren mit nahezu beliebiger Querschnittsfläche zerlegen. So sind z. B. runde, dreieckige oder sternförmige Aktoren herstellbar.

## Patentansprüche

1. Verfahren zur parallelen Herstellung mehrerer piezoelektrischer Aktoren mit folgenden Verfahrensschritten:
- Herstellen von dünnen Folien (1-3) aus einem ungebrannten, piezoelektrischen Keramikwerkstoff,
- Ausbilden von die Folien (1-3) durchdringenden ersten und zweiten Verbindungsöffnungen (11-16, 17-22), wobei jedem Aktor jeweils eine erste (11-16) und eine zweite (17-22) Verbindungsöffnung zugeordnet ist,
- Beschichten jeweils einer Oberfläche (4) der Folien (1-3) mit mehreren Elektroden (5-10), wobei jedem Aktor in jeder Folie (1-3) zumindest eine Elektrode (5-10) zugeordnet ist und
wobei die Verbindungsöffnungen (11-16, 17-22) die Folien (1-3) im Bereich der Elektroden (5-10) durchdringen und die Elektroden (5-10) jeweils eine Aussparung (23-28) aufweisen, die entweder die erste (11-16) oder zweite (17-22) Verbindungsöffnung umgibt,
- Stapeln einer Vielzahl von Folien (1-3) übereinander, so dass die ersten und zweiten Verbindungsöffnungen (11-16, 17-22) in einer dadurch entstehenden gestapelten Anordnung übereinander angeordnet sind,
wobei die Schichtenfolge der Folien (1-3) so gewählt ist, dass die übereinander angeordneten Verbindungsöffnungen (11-16, 17-22) alternierend nur in jeder zweiten Folien-Schicht (1-3) von einer Aussparung (23-28) der Elektroden (5-10) umgeben sind, so dass die Elektroden (5-10) abwechselnd entweder mit den ersten Verbindungsöffnungen (11-16) oder den zweiten Verbindungsöffnungen (17-22) in Verbindung stehen,
- Einbringen einer elektrisch leitenden Paste (53) in die Verbindungsöffnungen (11-16, 17-22),
- Brennen der gestapelten Anordnung, und
- Zertrennen der gestapelten Anordnung in einzelne Aktoren, **dadurch gekennzeichnet, dass** auf den Oberflächen (4) der Folien (1-3) im Randbereich zwischen den einzelnen Aktoren Zwischenbereiche (31) vorgesehen sind, die von den Elektroden (5-10) ausgespart sind, so dass das Zertrennen in einzelne Aktoren mit Abstand zu den jeweiligen Elektroden (5-10) erfolgt.

2. Verfahren nach Anspruch 1,
**dadurch gekennzeichnet,**
**dass** in den Zwischenbereichen (31) Perforationslöcher (30) ausgebildet werden.

3. Verfahren nach Anspruch 2,
**dadurch gekennzeichnet,**
**dass** die Perforationslöcher (30) in sich in den Zwischenbereichen (31) entlang der Ränder der einzelnen Aktoren erstreckenden Reihen angeordnet sind.

4. Verfahren nach Anspruch 2 oder 3,
**dadurch gekennzeichnet,**
**dass** zum Zertrennen der gestapelten Anordnung in die einzelnen Aktoren zwischen den Elektroden (5-10) benachbarter Aktoren ein elektrisches Feld entgegengesetzter Polarität angelegt wird.

5. Verfahren nach einem der Ansprüche 1 bis 4,
**dadurch gekennzeichnet,**
**dass** das Zertrennen der gestapelten Anordnung in die einzelnen Aktoren mittels Sägen oder Wasserstrahlschneiden erfolgt.

6. Verfahren nach einem der Ansprüche 1 bis 5,
**dadurch gekennzeichnet,**
**dass** die gestapelte Anordnung vor dem Brennen unter Druck bei einer erhöhten Temperatur getrocknet wird.

7. Verfahren nach einem der Ansprüche 1 bis 6,
**dadurch gekennzeichnet,**
**dass** die Elektroden (5-10) durch ein Siebdruckverfahren, Aufdampfen, Sputtern oder dergleichen aufgebracht werden.

8. Verfahren nach einem der Ansprüche 1 bis 7,
**dadurch gekennzeichnet,**
**dass** die gestapelte Anordnung beim Brennen unter uniaxialem Druck bei einer Temperatur von mindestens 1000 °C gesintert wird.

9. Piezoelektrischer Aktor, der eine Vielzahl von übereinander angeordneten Schichten (50) aus einem piezoelektrischen Keramikwerkstoff aufweist, die jeweils auf einer Oberfläche (4) mit zumindest einer Elektrode (5) beschichtet sind, wobei die Elektroden (5) alternierend miteinander verbunden sind und in jeder Schicht (50) eine erste und zweite die Schicht (50) im Bereich der Elektrode (5) durchdringende Verbindungsöffnung (11, 17) vorgesehen sind, wobei jede Elektrode (5) eine Aussparung (23) aufweist, die entweder die erste (11) oder zweite ( 17) Verbindungsöffnung umgibt, und die Schichten (50) so gestapelt sind, dass die ersten und zweiten Verbindungsöffnungen (11, 17) sämtlicher Schichten (50) übereinander angeordnet sind und die übereinander angeordneten Verbindungsöffnungen (11, 17) alternierend nur in jeder zweiten Schicht von einer Aussparung (23) der Elektroden (5) umgeben sind, so dass die Elektroden (5) abwechselnd mit den ersten Verbindungsöffnungen (11) und den zweiten Verbindungsöffnungen (17) in Verbindung stehen, und wobei die Verbindungsöffnungen (11, 17) mit einer elektrisch leitenden Paste (53) gefüllt sind,
**dadurch gekennzeichnet,**
**dass** die Schichten (50) einen umlaufenden Randbereich (31) aufweisen, der nicht mit der Elektrode (5) beschichtet ist.

10. Piezoelektrischer Aktor nach Anspruch 9,
**dadurch gekennzeichnet,**
**dass** die Elektroden (5) aus einer netzartigen Metallschicht bestehen.

11. Piezoelektrischer Aktor nach Anspruch 9 oder 10,
**dadurch gekennzeichnet,**
**dass** die äußere Oberfläche der obersten und/oder untersten Schicht und/oder der Randbereich des Aktors in eine elektrisch isolierende Vergussmasse eingebettet ist.

## Claims

1. Method for the parallel production of a number of piezoelectric actuators with the following method steps:
- producing thin sheets (1-3) from an unfired, piezoelectric ceramic material,
- forming first and second connecting openings (11-16, 17-22), penetrating the sheets (1-3), each actuator being respectively assigned a first connecting opening (11-16) and a second connecting opening (17-22),
- coating a respective surface (4) of the sheets (1-3) with a number of electrodes (5-10), each actuator in each sheet (1-3) being assigned at least one electrode (5-10), and
the connecting openings (11-16, 17-22) penetrating the sheets (1-3) in the region of the electrodes (5-10) and the electrodes (5-10) respectively having a clearance (23-28), which surrounds either the first connecting opening (11-16) or the second connecting opening (17-22),
- stacking a multiplicity of sheets (1-3) one on top of the other, so that the first and second connecting openings (11-16, 17-22) are arranged one on top of the other in a stacked arrangement created as a result,
the layer sequence of the sheets (1-3) being chosen such that the connecting openings (11-16, 17-22) arranged one on top of the other are surrounded by a clearance (23-28) of the electrodes (5-10) in an alternating manner only in every second sheet layer (1-3), so that the electrodes (5-10) are alternately in connection with the first connecting openings (11-16) or the second connecting openings (17-22),
- introducing an electrically conducting paste (53) into the connecting openings (11-16, 17-22),
- firing the stacked arrangement, and
- dividing up the stacked arrangement into individual actuators,
**characterized in that**, provided on the surfaces (4) of the sheets (1-3), in the edge region between the individual actuators, are intermediate regions (31), which are clear of the electrodes (5-10), so that the dividing-up into individual actuators takes place at a distance from the respective electrodes (5-10).

2. Method according to Claim 1, **characterized in that** perforation holes (30) are formed in the intermediate regions (31).

3. Method according to Claim 2, **characterized in that** the perforation holes (30) are arranged in rows extending in the intermediate regions (31) along the edges of the individual actuators.

4. Method according to Claim 2 or 3, **characterized in that**, for dividing up the stacked arrangement into the individual actuators, an electric field of opposed polarity is applied between the electrodes (5-10) of neighbouring actuators.

5. Method according to one of Claims 1 to 4, **characterized in that** the dividing up of the stacked arrangement into the individual actuators takes place by means of sawing or water-jet cutting.

6. Method according to one of Claims 1 to 5, **characterized in that** the stacked arrangement is dried under pressure at an elevated temperature before firing.

7. Method according to one of Claims 1 to 6, **characterized in that** the electrodes (5-10) are applied by a screen-printing process, vapour-depositing, sputtering or the like.

8. Method according to one of Claims 1 to 7, **characterized in that**, during firing, the stacked arrangement is sintered under uniaxial pressure at a temperature of at least 1000°C.

9. Piezoelectric actuator, which has a multiplicity of layers (50) of a piezoelectric ceramic material arranged one on top of the other, which are respectively coated on a surface (4) with at least one electrode (5), the electrodes (5) being interconnected in an alternating manner and a first and second connecting opening (11, 17) being provided in each layer (50), penetrating the layer (50) in the region of the electrode (5), each electrode (5) having a clearance (23), which surrounds either the first connecting opening (11) or the second connecting opening (17), and the layers (50) being stacked in such a way that the first and second connecting openings (11, 17) of all the layers (50) are arranged one on top of the other and the connecting openings (11, 17) arranged one on top of the other being surrounded by a clearance (23) of the electrodes (5) in an alternating manner only in every second layer, so that the electrodes (5) are alternately in connection with the first connecting openings (11) and the second connecting openings (17), and the connecting openings (11, 17) being filled with an electrically conducting paste (53), **characterized in that** the layers (50) have a peripheral edge region (31), which is not coated with the electrode (5).

10. Piezoelectric actuator according to Claim 9, **characterized in that** the electrodes (5) consist of a netting-like metal layer.

11. Piezoelectric actuator according to Claim 9 or 10, **characterized in that** the outer surface of the uppermost and/or lowermost layer and/or the edge region of the actuator is embedded in an electrically insulating casting compound.

## Revendications

1. Procédé de fabrication parallèle de plusieurs actionneurs piézo-électriques comprenant les étapes suivantes :
- fabrication de films minces (1-3) en une matière céramique piézo-électrique non cuite,
- formation de premiers et seconds orifices de liaison (11-16, 17-22) traversant les films (1-3), chaque actionneur ayant à chaque fois un premier (11-16) et un second (17-22) orifice de liaison,
- revêtement de chaque surface supérieure (4) des films (1-3) avec plusieurs électrodes (5-10), au moins une électrode (5-10) étant associée à chaque actionneur dans chaque film (1-3), et les orifices de liaison (11-16, 17-22) des films (1-3) passant dans la zone des électrodes (5-10) et ces électrodes (5-10) ayant chacune une cavité (23-28) qui entoure soit le premier orifice de liaison (11-16) soit le second orifice de liaison (17-22),
- empilage d'un grand nombre de films (1-3) les uns sur les autres pour que les premiers et seconds orifices de liaison (11-16, 17-22) soient superposés dans une disposition en forme de pile, la succession des couches des films (1-3) étant choisie pour que les orifices de liaison (11-16, 17-22) superposés soient entourés en alternance seulement dans chaque seconde couche de film (1-3) par une cavité (23-28) des électrodes (5-10) pour que les électrodes (5-10) soient reliées alternativement aux premiers orifices de liaison (11-16) et aux seconds orifices de liaison (17-22),
- introduction d'une patte électroconductrice (53) dans les orifices de liaison (11-16, 17-22),
- cuisson de la disposition empilée, et
- séparation de la disposition empilée en différents actionneurs,
**caractérisé en ce que**
sur la surface (4) des films (1-3), dans la zone du bord entre les différents actionneurs, on a des zones intermédiaires (31) dégagées des électrodes (5-10) pour que la séparation en différents actionneurs se fasse à distance des électrodes (5-10) respectives.

2. Procédé selon la revendication 1,
**caractérisé par**
des orifices de perforation (30) dans les zones intermédiaires (31).

3. Procédé selon la revendication 2,
**caractérisé en ce que**
les orifices de perforation (30) sont répartis dans les zones intermédiaires (31) dans des rangées le long des bords des différents actionneurs.

4. Procédé selon la revendication 2 ou 3,
**caractérisé en ce qu'**
on applique un champ électrique de polarité opposé entre les électrodes (5-10) d'actionneurs voisins pour séparer la disposition empilée en actionneurs distincts.

5. Procédé selon l'une des revendications 1 à 4,
**caractérisé en ce qu'**
on sépare la disposition empilée en différents actionneurs par sciage ou découpe au jet d'eau.

6. Procédé selon l'une des revendications 1 à 5,
**caractérisé en ce qu'**
avant la cuisson de la disposition empilée on sèche sous pression et à température élevée.

7. Procédé selon l'une des revendications 1 à 6,
**caractérisé en ce qu'**
on applique les électrodes (5-10) par un procédé de sérigraphie, par dépôt à la vapeur, par pulvérisation ou un procédé analogue.

8. Procédé selon l'une des revendications 1 à 7,
**caractérisé en ce qu'**
on fritte la disposition empilée par cuisson sous pression uniaxiale à une température d'au moins 1 000°C.

9. Actionneur piézo-électrique comportant un grand nombre de couches (50) empilées, ces couches étant en une matière céramique piézo-électrique, chaque couche étant revêtue sur sa surface (4) d'au moins une électrode (5),
les électrodes (5) étant reliées l'une à l'autre en alternance avec dans chaque couche (50) un premier et un second orifice de liaison (11, 17) qui traverse la couche (50) au niveau de l'électrode (5), chaque électrode (5) ayant une cavité (23) qui entoure soit le premier (11) soit le second (17) orifice de liaison, les couches (50) étant empilées pour que les premiers et seconds orifices de liaison (11-17) de toutes les couches (50) soient superposés et que les orifices de liaison (11-17) superposés ne soient entourés par une cavité (23) des électrodes (5) que dans chaque seconde couche, de sorte que les électrodes (5) sont reliées alternativement aux premiers orifices de liaison (11) et aux seconds orifices de liaison (17), et
les orifices de liaison (11, 17) étant remplis d'une patte électroconductrice (53),
**caractérisé en ce que**
les couches (50) ont une zone de bord (31) périphérique qui n'est pas revêtue par l'électrode (5).

10. Actionneur piézo-électrique selon la revendication 9,
**caractérisé en ce que**
les électrodes (5) sont formées d'une couche métallique en forme de réseau.

11. Actionneur piézo-électrique selon la revendication 9 ou 10,
**caractérisé en ce que**
la surface extérieure de la couche supérieure et/ou de la couche inférieure et/ou la zone de bord de l'actionneur est intégrée dans une masse coulée isolante électrique.
